# EUROPEAN PATENT SPECIFICATION

(11) **EP 0 769 206 B1**
(45) Date of publication and mention of the grant of the patent: **27.03.2002**
(21) Application number: 95925422.8
(22) Date of filing: 30.06.1995
(51) Int. Cl.: H01L 21/3205, H01L 27/115, H01L 21/316

(54) **THIN FILMS OF ABO3 WITH EXCESS A-SITE AND B-SITE MODIFIERS AND METHOD OF FABRICATING INTEGRATED CIRCUITS WITH SAME**
DÜNNE SCHICHTEN VON TYP ABO3 MIT ÜBERSCHUSS-A-TYP UND B-TYP ELEMENTEN UND HERSTELLUNGSVERFAHREN VON INTEGRIERTEN SCHALTUNGEN UNTER VERWENDUNG DIESER SCHICHTEN
MINCES FILMS ABO3 AVEC AGENTS MODIFIANTS DE SITES A ET B EN EXCES ET LEUR UTILISATION DANS UN PROCEDE DE FABRICATION DE CIRCUITS INTEGRES

(30) Priority: 05.07.1994 US 270510; 05.07.1994 US 270819
(43) Date of publication of application: 23.04.1997
(73) Proprietor: SYMETRIX CORPORATION, Colorado Springs, CO 80918 (US); MATSUSHITA ELECTRIC INDUSTRIAL CO., LTD., Kadoma-shi, Osaka-fu (JP)
(72) Inventor: AZUMA, Masamichi, Mishima-gun, Osaka 618 (JP); PAZ DE ARAUJO, Carlos, A., Colorado Springs, CO 80919 (US); SCOTT, Michael, C., Colorado Springs, CO 80918 (US)
(74) Representative: Goodanew, Martin Eric
(86) International application number: US9508296
(87) International publication number: WO9601493

(56) References cited:
- EP-A- 0 425 970
- EP-A- 0 459 575
- EP-A- 0 485 907
- DE-A- 2 361 230

## Description

### BACKGROUND OF THE INVENTION

### 1. Field of the Invention

This invention relates to the fabrication of thin films used in integrated circuits, more specifically to fabrication of materials used in high dielectric constant capacitors for integrated circuits.

### 2. Statement of the Problem

Metal oxide materials, such as barium strontium titanate ("BST"), have become important for making integrated circuit thin film capacitors having high dielectric constants. Such capacitors are useful in fabricating integrated circuit memories such as DRAMs. See for example, Kuniaki Koyama et al., "A Stacked Capacitor with (BaₓSr₁₋ₓ)TiO₃ For *256M* DRAM" in IDEM (International Electron Devices Meeting) *Technical Digest,* December 1991, pp. 32.1.1-32.1.4, and United States patent no. 5,122,923 issued to Shogo Matsubara et al. The capacitors used in a DRAM integrated circuit are the predominant element determining the size of each DRAM cell. To reduce the DRAM cell size, and thereby increase DRAM cell densities in an integrated circuit, requires reduction in the size of the capacitor. Reducing the capacitor size is achieved by increasing the dielectric constant of the material used in the dielectric layer of the capacitor so that a smaller surface area is required for a capacitor having desired dielectric properties. Prior methods for increasing the dielectric constant of material have also increased the leakage current of the material. Excessive leakage current renders the material unfit for capacitors in integrated circuits and in particular, unfit for capacitors in DRAM cells. It remains a problem in the field to increase the dielectric constant of materials, even for high dielectric constant material such as BST, without significantly increasing the leakage current.

### 3. Solution to the Problem

The present invention improves upon prior fabrication methods for BST to increase the dielectric constant of the dielectric material for use in integrated circuit memories, such as DRAMs, by blending excess A-site and B-site materials with the barium, strontium, and titanium liquid precursors used to produce the dielectric layer. The excess A-site and B-site materials increases the real part of the dielectric constant of the dielectric layer of the capacitor with little or no effect on leakage current. More particularly, the invention provides a method as defined in claim 1.

The process of the present invention includes blending of excess A-site and B-site materials such as barium and titanium with liquid precursors comprising barium, strontium, and titanium to form a homogenous liquid suitable for spin-on deposition processes. Liquid precursors suitable for this process are preferably metal carboxylates or metal alkoxides. US 5,514,822 recites the use of an alkoxycarboxylate liquid precursor in the fabrication of BST and a spin-on coating process. Applying similar "spin-on" methods for fabrication to the present invention permits more accurate control of the structure and distribution of the excess A-site and B-site materials within the BST dielectric layer of integrated circuit capacitors.

The quantity of excess A-site material or excess B-site material preferably ranges from an amount greater than zero (i.e., about 0.01 mole percent) to 100 mole percent ("mol%") of the stoichiometric amount that is required to satisfy the general formula ABO₃, wherein a 1:1:3 molar ratio exists between A (an A-site material), B (a B-site material), and oxygen. Accordingly, the total amount of A-site material preferably ranges from about 100.01 to about 200% of the stoichiometric amount from the general formula. This excess A-site material more preferably ranges from about 0.1 to 20 mol%, and most preferably ranges from about 1 to 3 mol% of the stoichiometric amount. Similarly, the excess B-site material preferably ranges from 0.01 to 100 mol%, more preferably ranges from about 0.1 to 20 mol%, and most preferably ranges from about 1 to 3% of the stoichiometric amount.

The precursor solution including excess A and B material is preferably applied to a substrate by utilizing a spin-on process to form a thin film. The coated substrate is then heated, preferably within the range of 100°C to 500°C, in order to remove the organic residue from the applied thin film. The thin film is preferably annealed at a temperature from about 600°C to 850°C in the presence of oxygen. These methods result in the fabrication of a high quality dielectric substance, such as BST, with excess A-site and B-site materials providing substantially improved dielectric properties for use in integrated circuit capacitors like DRAMs. Numerous other features, objects and advantages of the invention will become apparent from the following description when read in conjunction with the accompanying drawings.

### BRIEF DESCRIPTION OF THE DRAWINGS

FIG. 1 is a cross-sectional view of an integrated circuit capacitor that was fabricated according to the present invention;
FIG. 2 is a cross-sectional view of another embodiment of an integrated circuit capacitor that was fabricated according to the present invention and which includes low leakage dielectric buffer layers;
FIG. 3 is a cross-sectional view of a further exemplary embodiment of the present invention including an integrated circuit capacitor having adhesion and barrier layers;
FIG. 4 is a flow chart of a process according to the present invention for fabricating a BST capacitor having respective excesses of A-site and B-site materials;
FIG. 5 is a graph of the dielectric constant, ε, and dissipation factor, tan δ, versus excess titanium content for excess A-site and B-site materials, BST capacitors made according to the process of the invention;
FIG. 6 is a graph of the dielectric constant, ε, and dissipation factor, tan δ, versus excess titanium content for excess B-site material for BST capacitors made according to the process of the invention; and
FIG. 7 is a graph of the dielectric constant and current density versus dopant concentration for capacitors made with Dy₂O₃ - Cr₂O₃ and titanium dopants.

### DETAILED DESCRIPTION OF THE PREFERRED EMBODIMENT

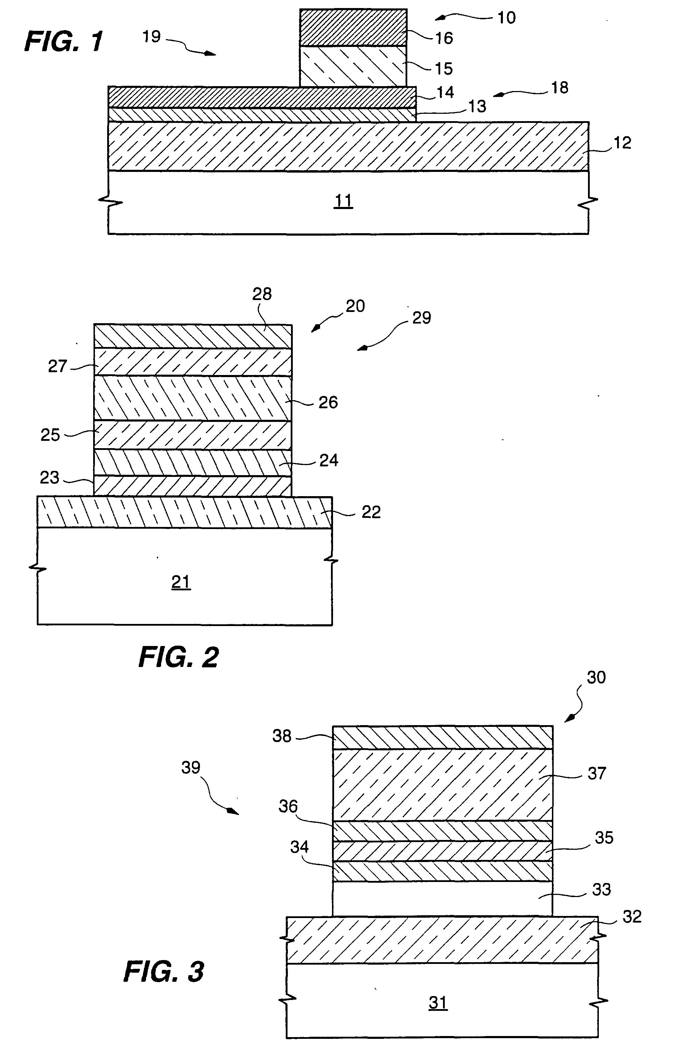

FIG. 1 depicts a thin film capacitor 10, which is fabricated according to the methods discussed below. As will be understood by those skilled in the art, the capacitor 10 is formed on a single crystal silicon wafer 11 having a thick layer 12 of silicon dioxide formed thereon. An adhesion layer 13 of titanium having a thickness of about 200 Å is then formed followed by a first electrode layer 14 of platinum having a thickness of about 2000 Å. Both layers 13 and 14 are preferably formed through the use of conventional sputtering protocols. A dielectric layer 15, which is made of BST, is formed adjacent first electrode layer 14. BST dielectric layer 15 includes excess A-site and B-site materials as described in detail below. A second platinum electrode 16 (also preferably about 2000 Å thick) is sputtered atop dielectric layer 15.

In the integrated circuit art, the silicon crystal 11 is often referred to as a "substrate." Herein, "substrate" may be used to refer to the silicon layer 11, but more generally will refer to any support for another layer. By way of example, the substrate 18 for the dielectric layer 15 is most immediately platinum first electrode 14, but also broadly includes layers 11, 12, and 13.

The BST layer is a metal oxide material of the general form ABO₃ where A and B are cations and O is the anion oxygens, and includes materials where A and B represent multiple elements; for example, it includes materials of the form A'A"BO₃, AB'B"O₃, and A'A"B'B"O₃, where A', A", B' and B" are different metal elements. Preferably, A, A', A", are metals selected from the group of metals consisting of Ba, Bi, Sr, Pb, Ca, and La, and B, B', and B" are metals selected from the group consisting of Ti, Zr, Ta, Mo, W, and Nb. A, A', and A" are collectively referred to herein as A-site materials. B, B', and B" are collectively referred to herein as B-site materials.

The crystalline metal oxide of layer 15 preferably has a perovskite type structure as will be understood by those skilled in the art. Many of these metal oxides are classified as ferroelectrics though some may not exhibit ferroelectricity at room temperature. Nevertheless, ferroelectrics of the invention typically have high dielectric constants, and are useful in high dielectric constant capacitors, whether or not they exhibit ferroelectric properties at normal operating temperatures.

In the present invention, excess A-site and B-site materials are blended with the metal oxide material. The "stoichiometric amount" of an A or B material hereof is hereby defined to be the amount required by the chemical formula for the stable compound. By way of example, a "stoichiometric" metal oxide precursor solution is a precursor solution including a plurality of metals, and in which the relative amounts of each metal in the solution has the same proportion as the proportion of the metal in the chemical formula for the desired metal oxide to be fabricated from the solution. In metal oxides having the formula ABO₃, there is one A-site atom and one B-site atom combined with three oxygen atoms (1:1:3); however the A-site and B-site material may be freely substituted for several equivalent materials as described above.

In a material having the form AA'BO₃, the ratio of A to A' A-site material is variable but the total number of A-site atoms is fixed as above with respect to B-site atoms and oxygen atoms. This ratio may be expressed as a formula template AₓA'₁₋ ₓBO₃ indicating that the total of A-site atoms equals one (X + 1 - X = 1) combined with one B-site atom and three oxygen atoms. Therefore, though the total of A-site and B-site atoms is fixed by the stoichiometric formula, the ratio of A to A' A-site atoms is expressed as the ratio X/(1-X).

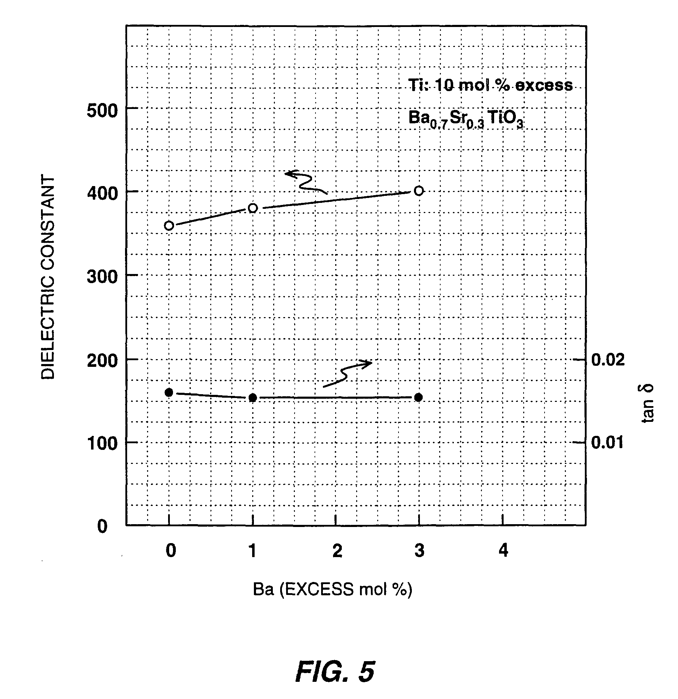

In the discussions herein, and particularly with respect to the abscissa of FIG. 5, the amount of excess A-site material is expressed in terms of mole % units (denoted mol%). This unit is a measure of the number of atoms of the excess A-site material as a percentage of the stoichiometric amount of A-site atoms in the underlying metal oxide material. For example, if the material is Ba_{0.7}Sr_{0.3}TiO₃, and the excess A-site material concentration is 10 mol%, then there are 10% more barium and 10% more strontium than would be present in a stoichiometric precursor solution. Similarly, if the excess B-site material concentration is 10 mol%, then there is 10% more titanium than is present in the stoichiometric precursor solution.

FIG. 2 depicts a second embodiment of a capacitor according to the invention, i.e., capacitor 20 including substrate 21, insulating layer 22, adhesion layer 23, first electrode 24, second electrode 28, buffer layers 25 and 27, and dielectric layer 26. Layer 26 is preferably a ferroelectric material or other metal oxide. Buffer layers 25 and 27 are made of BST, which is fabricated as described below, e.g., Ba_{0.3}Sr_{0.7}TiO₃ or Ba_{0.3}Sr_{0.7}TiO₃. Low-leakage buffer layers 25 and 27 are used when the principal dielectric 26 has more electrical leakage than is desirable. By way of example, non-volatile memories having ferroelectric materials of high polarizability may have an excessively high leakage current, and low-leakage buffer layers 25,27 can serve to decrease the overall leakage of the capacitor 20.

FIG. 3 depicts a third embodiment of the present invention, i.e., capacitor 30 including substrate 31, insulating layer 32, adhesion layer 34, first electrode 36, second electrode 38, and a dielectric material 37 made by the process described below. It also includes a polysilicon layer 33 and a barrier layer 35 that is preferably made of titanium nitride.

Other materials may be used the layers discussed above, such as silicon nitride for insulating layers 12, 22, and 32, gallium arsenide, indium antimonide, magnesium oxide, strontium titanate, sapphire or quartz for substrate 11, 21, or 31, and many other adhesion layer, barrier layer, and electrode materials. Furthermore, it should be understood that FIGS. 1 through 3 are not meant to be actual cross-sectional views of any particular portion of an actual electronic device, but are merely idealized representations which are employed to more clearly and fully depict the structure and process of the invention than would otherwise be possible. Accordingly, the relative thicknesses of the individual layers are not depicted proportionately; otherwise, some layers, such as the substrate 21 and insulator 22, would be so thick as to make the drawing unwieldy. Additionally, the respective capacitors 10, 20 and 30 preferably form a portion of an integrated circuit 19, 29, and 39, which also includes other electronic devices, such as transistors or other capacitors. These other devices are not depicted, for purposes of clarity. In addition, dielectric layers 15, 26, and 37 may be incorporated into other devices, such as ferroelectric FETs, as well as capacitors.

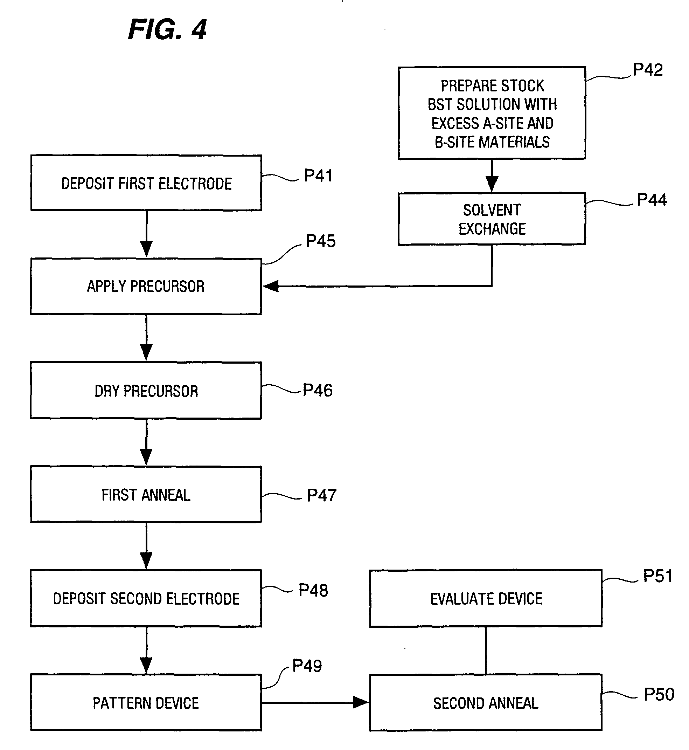

FIG. 4 depicts a flow chart of a process for fabricating capacitors 10, 20 and 30 of the present invention. The process shall be discussed in terms of the embodiment of FIG. 1, but be discussed equally well in terms of the other embodiments. In step P41 a first electrode 14 is deposited onto substrate 13, preferably by sputtering platinum as is known in the art.

In step P42, a BST solution is prepared with excess stoichiometric amounts of A-site and B-site materials, for subsequent use in step P45 and the eventual formation of dielectric layer 15. Step P42 may be completed at a time just prior to deposition of dielectric layer 15, but is generally done well in advance. The solution preparation steps P42 and P44 are preferably done under an inert atmosphere, such as an argon atmosphere.

An important feature of the invention is the ease with which specific excess A-site and B-site material concentrations can be added. In the prior art, which utilized methods such as doping, the precise dopant level achieved would be significantly less predictable and uniform when compared to that achieved using the methods of the present invention, due to inherent randomness in prior processes such as sputtering. Rather, in the prior art, one would fabricate a device, then test it to see what concentration was obtained. In contrast, the present method permits component fabrication that utilizes precise, uniform, and repeatable excess A-site and B-site material concentrations, and these concentrations are easily obtained. It should be apparent that the present invention lends itself to manufacturing much more readily than the prior art.

The BST stock solution is a precursor as generally described in US 5,514,822 but as will be described below in more detail, some differences exist between the US 5,514,822 solution and that of the present invention. These BST solutions are typically prepared by reacting barium with 2-methoxyethanol and 2-ethylhexanoic acid, adding strontium, allowing the mixture to cool, and adding titanium isopropoxide and 2-methoxyethanol.

The precursor of the present invention differs from that of US 5,514,822 in that excess quantities of A-site and B-site materials are added. Specifically, excess barium is added to the 2-methoxyethanol, and 2-ethylhexanoic acid and excess titanium isopropoxide are added to the 2-methoxyethanol to form a non-stoichiometric blend having excess A-site and B-site materials. The excess barium is blended to achieve an excess A-site material concentration ranging from about 0.01 to 100 mol%, as is the respective titanium, to achieve an excess B-site material concentration ranging from about 0.01 to 100 mol%. The blended solution is heated to obtain a final BST concentration of about 0.33 moles. Other organic complexes may be used in forming the precursor solution including: barium alkoxides, strontium alkoxides, and titanium alkoxides; barium carboxylates, strontium carboxylates, and titanium carboxylates. Particularly preferred alkoxides and carboxylates include barium 2-ethylhexanoate, strontium 2-ethylhexanoate, and titanium isopropoxide; barium 2-ethylhexanoate, strontium 2-ethylhexanoate, and titanium 2-ethylhexanoate; barium neodecanoate, strontium neodecanoate, and titanium isopropoxide; barium neodecanoate, strontium neodecanoate, and titanium neodecanoate; barium octanoates, strontium octanoates, and titanium octanoates.

After step 42, a solvent exchange step P44 is performed; however, this step, while very useful, is not absolutely necessary. This solvent exchange primarily substitutes a solvent that has a viscosity appropriate for the application process, e.g., the preferred "spin-on" process, for an initial solvent that is convenient for manufacturing the stock solution and/or which makes a precursor that stores well. An appropriate viscosity herein preferably means a lower viscosity than the stock solution. In this solvent exchange, xylene is most preferably exchanged for the 2-methoxyethanol solvent of the BST stock solution. Accordingly, xylene may be added to the stock solution, which is then heated to about 130°C while stirring to boil away the other stock solvents like 2-methoxyethanol. This solvent exchange step, while very useful, is not necessary. N-butyl acetate also works well as a solvent, and may be substituted for xylene in the solvent exchange.

This method of forming the liquid precursor permits extremely accurate amounts of the excess A-site and B-site materials to be added to the BST, and the thorough stirring in the solvent exchange step, or other mixing step, ensures uniform dispersion of the excess A-site and B-site materials throughout the BST.

The use of carboxylates in this process significantly enhances the results, because gels are not formed, otherwise, gel formation could tend to impede the mixing and the uniform dispersion of the excess A-site and B-site materials into the BST. All of the liquid chemicals that are used in making the precursors, such as xylene, n-butyl acetate, and 2-methoxyethanol are preferably semiconductor grade chemicals, which is a well-known term in the semiconductor art.

In step P45, the precursor solution from step P44 is applied to the substrate 18. This treating step is preferably conducted by applying the precursor solution to substrate 18 and spinning substrate 18 at from about 1000 RPM to 2000 RPM for a time ranging from about 20 seconds to 60 seconds; however, other application methods may be used. By way of example, it is possible to use an alternative misted deposition process as is described in US 5,456,945.

In steps P46 and P47, the precursor is treated to form a BST dielectric material 15 on substrate 18. This treating step is preferably completed by drying and annealing the result of step P45. In step P46, the precursor is dried, preferably in dry air or nitrogen, and preferably at a relatively high temperature as compared to the prior art, i.e., at from about 100°C to 500°C for a time ranging between about one minute to about thirty minutes. Most preferably, drying is performed in air at about 400°C for a time ranging from about 2 to 10 minutes. This high temperature drying step is important in obtaining predictable properties in BST with excess A-site and B-site materials added.

In step P47, the dried precursor is annealed to form dielectric layer 15. This annealing step is referred to as the first annealing to distinguish it from a later annealing step. The first anneal is preferably performed in oxygen at a temperature of from about 600°C to 850°C. This step is most preferably conducted at a temperature of about 800°C for about 60 minutes in O₂ in a push/pull process including 10 minutes for the "push" into the furnace and 10 minutes for the "pull" out of the furnace. Careful control of the annealing temperature and time is also important for predicable dielectric layer results.

In step P48 a second electrode 16 is deposited as discussed above. The device is then patterned, which may comprise only the patterning of the second electrode if any patterning was done after deposition of the first electrode. It is important that the device be patterned before the second anneal step P50 so that patterning stresses are removed by the annealing step, and any oxide defects created by the patterning are corrected.

The second annealing step, at step P50, is preferably performed at the same temperature as the first anneal in step P47, though variance within a small temperature range of from about 50°C to 100°C with respect to the first annealing temperature is possible depending on the excess A-site and B-site materials that may be selected as set forth above. The time for the second anneal is preferably less than for the first anneal, and is generally about 30 minutes in duration, though a range of time from about 20 minutes to 90 minutes is possible depending on the sample. Again, careful control of the annealing parameters is important to obtain predictable results. Finally, in step P51 the device is completed and evaluated.

Another factor that is important in obtaining good, predictable results in the dielectric materials is the use of high purity barium, strontium and titanium in making the precursors. Usually, what is called "high purity" barium, strontium, and titanium in the trade has impurity levels of between 1 in 10⁴ and 1 in 10⁵ atoms of impurities for the more abundant elements. Impurity levels this high will be referred to herein as "R&D grade" materials. Precursor solutions made with such R&D grade materials do not provide sufficiently predictable results for materials used in the present invention. The methods of the present invention require the use of material with higher purity, i.e. with impurities of less than 1 in 10⁵ atoms of impurities for any one element, or less than 10 parts per million.

Accordingly, a further feature of the invention is that the BST precursors preferably contain impurities of less than 10 parts per million per impurity element. Relatively small amounts of impurities appear to give the best results in many cases. The normal level of impurity content in R&D grade BST may interfere with the desired dielectric properties. Moreover, since small amounts of impurities can make a significant difference in the electrical properties, for the results to be predictable, the material preferably should have impurities of 10 parts per million or less for each impurity element.

### Examples

The following non-limiting examples set forth preferred methods and materials that may be utilized to practice the present invention.

### Example 1: Reagent Purity Determination

Table 1 contains the measured impurity levels in parts per million for the higher purity precursor solutions and the R&D grade precursor solutions. Where an entry is left blank the impurity was not specified.

**TABLE 1**

| IMPURITY | HIGH PURITY SOLUTION Impurity Level in PPM | R & D SOLUTION Impurity Level in PPM |
|---|---|---|
| Na | 43 | 65 |
| K | 2.4 | 52 |
| Mn | 0.6 | 31 |
| Fe | < 0.3 | 8 |
| Ni | 0.2 | |
| Mg | < 0.1 | |
| Ca | 1.9 | |
| Zn | 0.1 | |
| Al | 0.3 | |
| Ag | < 0.1 | |
| Cd | < 0.1 | |
| Cu | 0.6 | |
| Li | < 0.1 | |
| Mo | < 2 | |
| Co | < 0.1 | |
| Cr | < 0.05 | |
| U | < 0.002 | < 5 |
| Th | < 0.002 | < 5 |

As indicated in Table 1, the "high purity" solution included no impurity element in a concentration greater than 4.3 parts per million, and the total of all impurities was only about 13 parts per million. The R&D grade solutions had impurity levels of 10 to 100 times higher. Preferably, for use in the present invention, the impurity level for most impurities will be 1 part per million or less.

### Example 2: Production of BST Films on an Electrode by Using Excess A and B Site Materials

Various samples were produced with excess A-site and B-site materials added in accord with the methods of the present invention.

A standard stock solution containing 0.33 M BST (Ba_{0.7}Sr_{0.3}TiO₃) in 2-methoxyethanol was supplemented with 10 mol% titanium added as the excess B-site material, and 0 mol% barium as the excess A-site material.

After the A and B-site material supplementation, a xylene exchange was performed on the mixture. Xylene was introduced into the mixture in an amount sufficient to replace the 2-methoxyethanol, and the solution was heated to about 130°C to distill off the non-xylene solvent fraction. Ignoring the excess A and B-site materials, the final precursor solution had a BST concentration of 0.32 M in xylene.

The precursor was applied to the substrate 14 under an inert atmosphere, spun at 1500 RPM for about 30 seconds, dried at 400°C for 2 minutes on a hot plate in air, and annealed at 750°C in oxygen for 70 minutes including a 10 minute push in and 10 minutes pull out. The final thickness of the BST layer 15 was 1600 Å.

Platinum top electrode 16 was deposited by sputtering and patterned. Capacitor 10 was then annealed again at 750°C for 30 minutes in oxygen, including a 10 minute push in and pull out.

These method steps were repeated for two other samples by substituting different amounts for the 0% A-site material that was utilized above. Barium was added as the excess A-site material in amounts equating to 1% and 3% of the stoichiometric amount.

The electrical properties of the samples were measured according to standard techniques. FIG. 5 depicts a comparison of the electrical properties of the samples which were thus evaluated. The FIG. 5 results include the real part of the dielectric constant, ε (indicated with open circles), the scale for which is on the left, and the dissipation factor, tan δ (indicated with filled circles), the scale for which is on the right. The abscissa for both ordinates is the excess A-site barium content in mol%. The dielectric constant steadily rises with increased excess A-site barium, while the dissipation factor falls slightly or remains about the same.

### Example 3: Production of BST Films on an Electrode by Using Excess B-Site Materials

Various samples were produced with excess B-site material added to precursor solutions in accord with the methods of the present invention.

A standard stock solution containing 0.33 M BST (Ba_{0.7}Sr_{0.3}TiO₃) in 2-methoxyethanol was supplemented with 1 mol% titanium added as the excess B-site material.

After the B-site material supplementation, a xylene exchange was performed on the mixture. Xylene was introduced into the mixture in an amount sufficient to replace the 2-methoxyethanol to be removed by distillation, and the solution was heated to about 130°C to distill off the non-xylene solvent fraction. Ignoring the excess B-site materials, the final precursor solution had a molarity of 0.32 M.

The precursor was applied to the substrate 18 under an inert atmosphere, spun at 1500 RPM for about 30 seconds, dried at 400°C for 2 minutes on a hot plate in air, and annealed at 750°C in oxygen for 70 minutes including a 10 minute push in and 10 minutes pull out. The final thickness of the BST layer 15 was 1600 Å.

Top electrode 16 was deposited and patterned. Capacitor 10 was then annealed again at 750°C for 30 minutes in oxygen, including a 10 minute push in and pull out.

These method steps were repeated for four other samples by substituting different amounts for the 1% B-site material that was utilized above. These four additional samples were fabricated with titanium as the excess B-site material added to concentrations of 0 mol% (control), 3 mol%, 5 mol%, and 10 mol%. This first set of five total samples was annealed at 750°C, in like manner with the sample for the first (1%) concentration.

A second set of five samples, including concentrations identical to the first set were fabricated using the same excess B-site material concentrations as above but were annealed at 800°C.

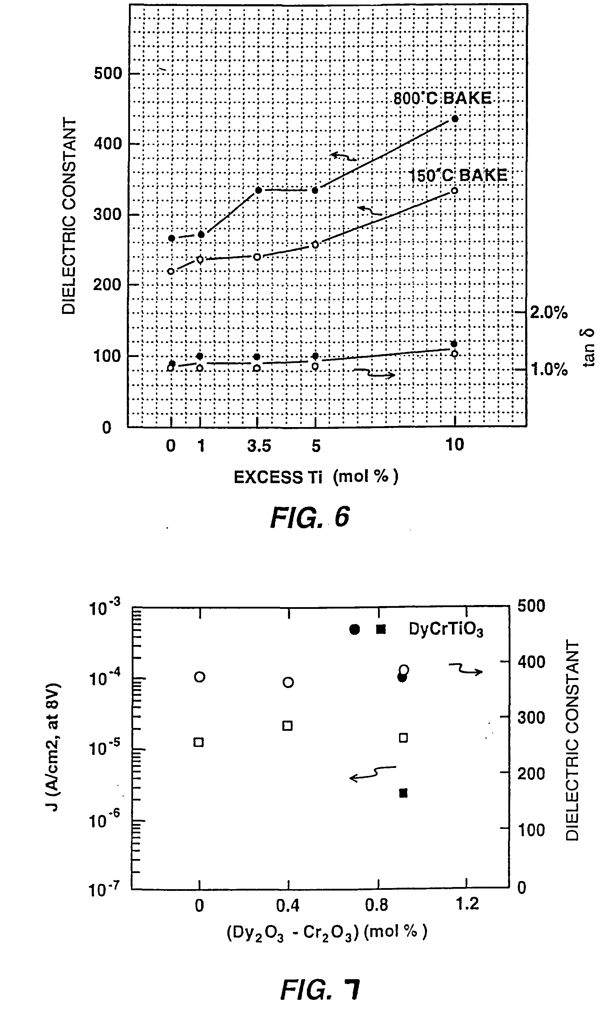

The electrical properties of the ten samples were measured according to standard techniques. FIG. 6 depicts a comparison of the electrical properties of the ten samples were thus evaluated. The FIG. 6 results include the real part of the dielectric constant, ε, the scale for which is on the left, and the dissipation factor, tan δ, the scale for which is on the right. The abscissa for both ordinates is the excess B-site titanium content in mole percent. The measurements for the samples which were annealed at 750°C are shown with open circles, while the measurements for the samples which were annealed at 800°C are shown by filled circles. The dielectric constant steadily rises with increased excess B-site titanium, while the dissipation factor only rises slightly or remains about the same. The anneal temperature makes a significant difference with respect to the dielectric constant, ε, but makes little difference with respect to the dissipation factor, tan δ.

A third set of 3 sample capacitors 10 as shown in FIG. 1 were also made. In two samples of the set a mixture of dysprosium oxide, Dy₂O₃, and chromium oxide, Cr₂O₃, was the dopant material in Ba_{0.7}Sr_{0.3}TiO₃. Dy₂O₃ is considered to be an A-site dopant while Cr₂O₃ is considered to a B-site dopant. In the first sample the amount of Dy₂O₃ - Cr₂O₃ dopant was 0.4 mole %, i.e. 0.4 mol % of Dy₂O₃ and 0.4 mole % of Cr₂O₃, and in the second sample the amount of Dy₂O₃ - Cr₂O₃ dopant was 1.0 mole %. In the third sample, the dopant was the same as the second sample except that 1.0 mole % of a second B-site dopant, titanium, was also added. In each case, the stock BST solution was a 0.5 M BST solution (R & D grade), made as described above and diluted to 03M with n-butyl acetate; e.g. 2 ml of the above BST solution were added to 1.3 ml n-butyl acetate to yield the final BST precursor solution. The dopant solution was the metal 2-ethylhexanoate in xylene, with about 0.1109 mmole of Dy, 0.0366 mmole of chromium, and 0.9144 mmole of titanium per gram, respectively, for the three dopant precursors. The solution was spun at between 1600 rpm and 2000 rpm and yielded a film of about 700 Å - 900 Å per coat. The drying step P46 was performed at 400°C on a hot plate, in air for 2 minutes. The first anneal step P47 was at 750°C for 80 minutes in O_{2,} and the 2nd anneal P50 was at 750°C for 30 minutes in O₂. The thickness of the dielectric 15 in the samples was from 1440 Å to 1510 Å.

The three samples were tested and compared with the sample with no doping with the results shown in FIG. 7. In this figure, the dielectric constant (indicated by circles) and current density, **J**, in amps/cm² (indicated by squares) are plotted as a function of concentration of the Dy₂O₃ - Cr₂O₃ dopant in mol. %. The solid symbols are for the titanium-doped sample. The dielectric constant and the current density for the Dy₂O₃ - Cr₂O₃ doping vary only a little from the results for the Ba_{0.7}Sr_{0.3}TiO₃ thin film, however the addition of the titanium B-site dopant significantly improves the current density, i.e. drops it nearly a factor of 10, without appreciably changing the dielectric constant. This again indicates that the use of B-site titanium doping can be advantageous to optimize the electrical properties of BST to permit the fabrication of BST thin films that are practical for use in integrated circuits.

There have been described novel structures and processes for fabricating integrated circuit capacitors using BST with excess A-site and B-site materials added. It should be understood that the particular embodiments shown in the drawings and described within this specification are exemplary in nature, and should not be construed to limit the invention. For example, the materials and methods described with respect to the capacitor 10 of FIG. 1 may be used with other capacitor structures, such as that of FIG. 3 or many other variations of capacitors; or the buffer layers 25 and 27 of FIG. 2 may be used in combination with the capacitors of FIGS. 1 and 3 as well as other capacitor structures. The structures and processes may be combined with a wide variety of other structures and processes. Equivalent materials, different material thicknesses, and other methods of depositing the substrate and electrode layers may be used. It is also evident that the process steps recited may in some instances be performed in a different order, or equivalent structures and processes may be substituted for the various structures and processes described.

## Claims

1. A method of fabricating an integrated circuit (10, 20, 30) containing a thin film barium strontium titanate layer (15, 26, 37), comprising the steps of:
providing a liquid precursor comprising barium, strontium and titanium in stoichiometric proportions satisfying the formula ABO₃ where A is constituted by a mixture of barium and strontium, B is titanium, and O is oxygen;
blending (P42) excess A-site material and excess B-site material into said liquid precursor to form a solution, said excess A-site material being selected from the group consisting of Ba, Sr, Dy, Bi, Pb, Ca and La, and said excess B-site material being selected from the group consisting of Ti, Cr, Zr, Ta, Mo, W and Nb;
applying (P45) said solution to a substrate; and
heat treating (P46, P47) said solution on said substrate to form a thin film barium strontium titanate layer containing said excess A-site and B-site materials on said substrate.

2. A method according to claim 1, wherein in said formula ABO₃ is Ba_{0.7}Sr_{0.3}TiO₃.

3. A method according to claim 1, wherein said liquid precursor contains the A-site and B-site materials as substituents to an organic complex.

4. A method according to claim 3, wherein said organic complex is selected from the group consisting of barium alkoxides, strontium alkoxides, titanium alkoxides, barium carboxylates, strontium carboxylates, titanium carboxylates, and mixtures thereof.

5. A method according to claim 1, wherein said excess A-site material is dysprosium, and said excess B-site material is chromium.

6. An integrated circuit (10, 20, 30) comprising a substrate and a thin film (15, 26, 37) of barium strontium titanate formed on said substrate, said barium strontium titanate satisfying the formula ABO₃ where A is a mixture of barium and strontium, B is titanium and O is oxygen, and said thin film containing excess A-site material and excess B-site material, said excess A-site material being selected from the group consisting of Ba, Sr, Dy, Bi, Pb, Ca and La, and said excess B-site material being selected from the group consisting of Ti, Cr, Zr, Ta, Mo, W and Nb.

7. An integrated circuit according to claim 6, wherein said excess A-site material is dysprosium and said excess B-site material is chromium.

## Patentansprüche

1. Verfahren zum Herstellen einer integrierten Schaltung (10, 20, 30) enthaltend eine Dünnfilm-Barium-Strontium-Titanat-Schicht (15, 26, 37), umfassend die Schritte, daß man:
eine flüssige Vorstufe bereitstellt, umfassend Barium, Strontium und Titan in stöchiometrischen Verhältnissen, die die Formel ABO₃ erfüllen, in der A durch eine Mischung von Barium und Strontium repräsentiert wird, B Titan und O Sauerstoff ist;
Überschuß-A-Stellen-Material und Überschuß-B-Stellen-Material in die genannte Vorstufe mischt (P42), um eine Lösung zu bilden, wobei das Überschuß-A-Stellen-Material gewählt ist aus der Gruppe bestehend aus Ba, Sr, Dy, Bi, Pb, Ca und La und das Überschuß-B-Stellen-Material gewählt ist aus der Gruppe bestehend aus Ti, Cr, Zr, Ta, Mo, W und Nb;
die Lösung auf ein Substrat aufbringt (P45); und die Lösung auf dem Substrat hitzebehandelt (P46, P47) um eine Dünnfilm-Barium-Strontium-Titanat-Schicht zu bilden, die die Überschuß A-Stellen- und B-Stellen-Materialien auf dem Substrat enthält.

2. Verfahren gemäß Anspruch 1, in dem die Formel ABO₃ Ba_{0,7}Sr_{0,3}TiO₃ ist.

3. Verfahren gemäß Anspruch 1, in dem die flüssige Vorstufe die A-Stellen- und B-Stellen-Materialien als Substituenten eines organischen Komplexes enthält.

4. Verfahren gemäß Anspruch 3, in dem der organische Komplex gewählt ist aus der Gruppe bestehend aus Bariumalkoxiden, Strontiumalkoxiden, Titanalkoxiden, Bariumcarboxylaten, Strontiumcarboxylaten, Titancarboxylaten und Mischungen davon.

5. Verfahren gemäß Anspruch 1, in dem das Überschuß-A-Stellen-Material Dysprosium und das Überschuß-B-Stellen-Material Chrom ist.

6. Integrierte Schaltung (10, 20, 30), umfassend ein Substrat und einen dünnen Film (15, 26, 37) aus Barium-Strontium-Titanat, gebildet auf dem Substrat, wobei das Barium-Strontium-Titanat die Formel ABO₃ erfüllt, in der A eine Mischung von Barium und Strontium ist, B Titan ist und O Sauerstoff ist und der dünne Film Überschuß-A-Stellen-Material und Überschuß-B-Stellen-Material enthält, wobei das Überschuß-A-Stellen-Material gewählt ist aus der Gruppe bestehend aus Ba, Sr, Dy, Bi, Pb, Ca und La, und das Überschuß-B-Stellen-Material gewählt ist aus der Gruppe bestehend aus Ti, Cr, Zr, Ta, Mo, W und Nb.

7. Integrierte Schaltung gemäß Anspruch 6, in der das Überschuß-A-Stellen-Material Dysprosium ist und das Überschuß-B-Stellen-Material Chrom ist.

## Revendications

1. Procédé de fabrication d'un circuit intégré (10, 20, 30) qui contient une couche de titanate de baryum-strontium en film mince (15, 26, 37), comprenant les étapes de :
fourniture d'un précurseur liquide comprenant du baryum, du strontium et du titane selon des proportions stoechiométriques qui satisfont la formule ABO₃ où A est constitué par un mélange de baryum et de strontium, B est du titane et O est de l'oxygène ;
mélange (P42) d'un matériau de site A en excès et d'un matériau de site B en excès dans ledit précurseur liquide afin de former une solution, ledit matériau de site A en excès étant choisi parmi le groupe comprenant Ba, Sr, Dy, Bi, Pb, Ca et La et ledit matériau de site B en excès étant choisi parmi le groupe comprenant Ti, Cr, Zr, Ta, Mo, W et Nb ;
application (P45) de ladite solution sur un substrat ; et
traitement thermique (P46, P47) de ladite solution sur ledit substrat afin de former une couche de titanate de baryum-strontium en film mince qui contient lesdits matériaux de site A et de site B en excès sur ledit substrat.

2. Procédé selon la revendication 1, dans lequel, dans ladite formule, ABO₃ est Ba_{0,7}Sr_{0,3}TiO₃.

3. Procédé selon la revendication 1, dans lequel ledit précurseur liquide contient des matériaux de site A et de site B en tant que substituants pour un complexe organique.

4. Procédé selon la revendication 3, dans lequel ledit complexe organique est choisi parmi le groupe comprenant des alkoxydes de baryum, des alkoxydes de strontium, des alkoxydes de titane, des carboxylates de baryum, des carboxylates de strontium, des carboxylates de titane et des mélanges de ceux-ci.

5. Procédé selon la revendication 1, dans lequel ledit matériau de site A en excès est du dysprosium et ledit matériau de site B en excès est du chrome.

6. Circuit intégré (10, 20, 30) comprenant un substrat et un film mince (15, 26, 37) en titanate de baryum-strontium qui est formé sur ledit substrat, ledit titanate de baryum-strontium satisfaisant la formule ABO₃ où A est un mélange de baryum et de strontium, B est du titane et O est de l'oxygène, et ledit film mince contient un matériau de site A en excès et un matériau de site B en excès, ledit matériau de site A en excès étant choisi parmi le groupe comprenant Ba, Sr, Dy, Bi, Pb, Ca et La et ledit matériau de site B en excès étant choisi parmi le groupe comprenant Ti, Cr, Zr, Ta, Mo, W et Nb.

7. Circuit intégré selon la revendication 6, dans lequel ledit matériau de site A en excès est du dysprosium et ledit matériau de site B en excès est du chrome.
